# EUROPEAN PATENT APPLICATION

(11) **EP 2 884 536 A1**
(43) Date of publication of application: **17.06.2015**
(21) Application number: 14195599.7
(22) Date of filing: 01.12.2014
(51) Int. Cl.: H01L 27/02, H03K 17/081

(54) **Group III-V voltage converter with monolithically integrated level shifter, high side driver, and high side power switch**

(30) Priority: 09.12.2013 US 201361913548 P; 26.11.2014 US 201414554838
(71) Applicant: International Rectifier Corporation, El Segundo, CA 90245 (US)
(72) Inventor: Briere, Michael A., Scottsdale, AZ Arizona 85266 (US)
(74) Representative: Dr. Weitzel & Partner

(57) **Abstract**

There are disclosed herein various implementations of a monolithically integrated high side block. Such a monolithically integrated high side block includes a level shifter, a high side driver coupled to the level shifter, and a high side power switch coupled to the high side driver. The high side power switch is monolithically integrated with the high side driver and the level shifter on a common die. Each of the level shifter, the high side driver, and the high side power switch includes at least one group III-V device.

## Description

### BACKGROUND

The present application claims the benefit of and priority to a provisional application entitled "Integrated III-Nitride High Side Switch," Serial No. 61/913,548 filed on December 9, 2013. The disclosure in this provisional application is hereby incorporated fully by reference into the present application.

### I. DEFINITION

As used herein, the phrase "group III-V" refers to a compound semiconductor including at least one group III element and at least one group V element. By way of example, a group III-V semiconductor may take the form of a III-Nitride semiconductor. "III-Nitride" or "III-N" refers to a compound semiconductor that includes nitrogen and at least one group III element such as aluminum (Al), gallium (Ga), indium (In), and boron (B), and including but not limited to any of its alloys, such as aluminum gallium nitride (AlₓGa₍₁₋ₓ₎N), indium gallium nitride (In_{y}Ga_{(1-y)}N), aluminum indium gallium nitride (AlₓIn_{y}Ga_{(1-x-y)}N), gallium arsenide phosphide nitride (GaAsₐP_{b}N_{(1-a-b)}), aluminum indium gallium arsenide phosphide nitride (AlₓIn_{y}Ga_{(1-x-y)}AsₐP_{b}N_{(1-a-b)}), for example. III-N also refers generally to any polarity including but not limited to Ga-polar, N-polar, semi-polar, or non-polar crystal orientations. A III-N material may also include either the Wurtzitic, Zincblende, or mixed polytypes, and may include single-crystal, monocrystalline, polycrystalline, or amorphous structures. Gallium nitride or GaN, as used herein, refers to a III-N compound semiconductor wherein the group III element or elements include some or a substantial amount of gallium, but may also include other group III elements in addition to gallium.

In addition, as used herein, the phrase "group IV" refers to a semiconductor that includes at least one group IV element such as silicon (Si), germanium (Ge), and carbon (C), and may also include compound semiconductors such as silicon germanium (SiGe) and silicon carbide (SiC), for example. Group IV also refers to semiconductor materials which include more than one layer of group IV elements, or doping of group IV elements to produce strained group IV materials, and may also include group IV based composite substrates such as single-crystal or polycrystalline SiC on silicon, silicon on insulator (SOI), separation by implantation of oxygen (SIMOX) process substrates, and silicon on sapphire (SOS), for example.

It is noted that, as used herein, the terms "low voltage" or "LV" in reference to a transistor or switch describes a transistor or switch with a voltage range of up to approximately fifty volts (50V). It is further noted that use of the term "midvoltage" or "MV" refers to a voltage range from approximately fifty volts to approximately two hundred volts (approximately 50V to 200V). Moreover, the term "high voltage" or "HV," as used herein, refers to a voltage range from approximately two hundred volts to approximately twelve hundred volts (approximately 200V to 1200V), or higher.

### II. BACKGROUND ART

In high power and high performance circuit applications, group III-V power devices, such as III-Nitride or other group III-V field-effect transistors (FETs) or high mobility electron transistors (HEMTs), are often desirable for their high efficiency and high-voltage operation. III-Nitride and other group III-V HEMTs operate using polarization fields to generate a two-dimensional electron gas (2DEG) allowing for high current densities with low resistive losses. Such III-Nitride or other group III-V HEMTs may be implemented as high side and/or low side power switches in a DC-DC power converter, for example.

When utilized as a high side power switch, a III-Nitride or other group III-V HEMT may be driven by a high side driver stage that may contain silicon based driver and pre-driver switches, and may be further implemented with a level shifter also including silicon based switches. However, silicon based switches typically have higher device capacitances than III-Nitride or other group III-V based switches. As a result, one disadvantage of using silicon based switches in the level shifter and high side driver stage is the adverse effect that their higher capacitance can have on the speed and overall performance of the high side power switch. Moreover, in some applications it may be desirable to have as many of the features of the high side driver and level shifter be monolithically integrated on a common die with the high side power switch as possible. Such monolithic integration may enable advantageous reduction in the size and cost of the high side switching circuitry, while improving performance by reducing the parasitic inductances and capacitances associated with device layout and interconnection.

### SUMMARY

The present disclosure is directed to a group III-V voltage converter with monolithically integrated level shifter, high side driver, and high side power switch, substantially as shown in and/or described in connection with at least one of the figures, and as set forth more completely in the claims.

### BRIEF DESCRIPTION OF THE DRAWINGS

Figure 1 shows a diagram of a monolithically integrated high side block, according to one exemplary implementation.
Figure 2A shows a diagram of an exemplary group III-V level shifter suitable for use in a monolithically integrated high side block, according to one implementation.
Figure 2B shows a diagram of an exemplary group III-V level shifter suitable for use in a monolithically integrated high side block, according to another implementation.
Figure 3 shows a diagram of a group III-V high side driver suitable for use in a monolithically integrated high side block, according to one implementation.
Figure 4A shows an exemplary group III-V transistor suitable for use in a monolithically integrated high side block, according to one implementation.
Figure 4B shows an exemplary composite transistor suitable for use in a monolithically integrated high side block, according to one implementation.
Figure 5 shows a diagram of a voltage converter including a monolithically integrated high side block, according to one exemplary implementation.

### DETAILED DESCRIPTION

The following description contains specific information pertaining to implementations in the present disclosure. One skilled in the art will recognize that the present disclosure may be implemented in a manner different from that specifically discussed herein. The drawings in the present application and their accompanying detailed description are directed to merely exemplary implementations. Unless noted otherwise, like or corresponding elements among the figures may be indicated by like or corresponding reference numerals. Moreover, the drawings and illustrations in the present application are generally not to scale, and are not intended to correspond to actual relative dimensions.

As noted above, in high power and high performance circuit applications, group III-V power devices, such as III-Nitride or other group III-V field-effect transistors (FETs) or high mobility electron transistors (HEMTs), are often desirable for their high efficiency and high-voltage operation. III-Nitride and other group III-V HEMTs operate using polarization fields to generate a two-dimensional electron gas (2DEG) allowing for high current densities with low resistive losses. Such III-Nitride or other group III-V HEMTs may be implemented as high side and/or low side power switches in a DC-DC power converter, for example.

As also noted above, when utilized as a high side power switch, a III-Nitride or other group III-V HEMT may be driven by a high side driver stage that may contain silicon based driver and pre-driver switches, and may be further implemented with a level shifter also including silicon based switches. However, silicon based switches typically have higher device capacitances than III-Nitride or other group III-V based switches. As a result, one disadvantage of using silicon based switches in the level shifter and high side driver stage is the adverse effect that their higher capacitance can have on the speed and overall performance of the high side power switch. Moreover, in some applications it may be desirable to have as many of the features of the high side driver and level shifter be monolithically integrated on a common die with the high side power switch as possible.

By way of example, several specific integrated power circuits are disclosed in U.S. Patent Number 7,863,877, entitled "Monolithically Integrated III-Nitride Power Converter", filed on December 4, 2007, and issued on January 4, 2011; U.S. Patent Number 8,148,964, entitled "Monolithic III-Nitride Power Converter", filed on November 29, 2010, and issued on April 3, 2012; U.S. Patent Number 8,476,885, entitled "Monolithic Group III-V Power Converter", filed on March 27, 2012, and issued on July 2, 2013; and U.S. Patent Number 8,063,616, entitled "Integrated III-Nitride Power Converter Circuit", filed on January 11, 2008, and issued on March 22, 2011. The above identified patents are hereby incorporated fully by reference into the present application.

The present application is directed to implementations of a monolithically integrated high side block configured to overcome the deficiencies associated with conventional implementations utilizing silicon based transistors to provide high side driver and level shifter circuitry. In various implementations, a monolithically integrated high side block according to the present inventive concepts may integrate a high side group III-V power switch, as well as the high side driver and level shifter for the high side group III-V power switch, on a common die. Moreover, the switching devices utilized in either or both of the high side driver and level shifter may be implemented as group III-V depletion mode (i.e., normally on), group III-V enhancement mode (i.e., normally off), or enhancement mode composite devices. The monolithically integrated high side block disclosed herein enables advantageous reduction in the size and cost of the high side power switching circuitry, while improving performance by reducing parasitic inductances and capacitances associated with device layout and interconnection.

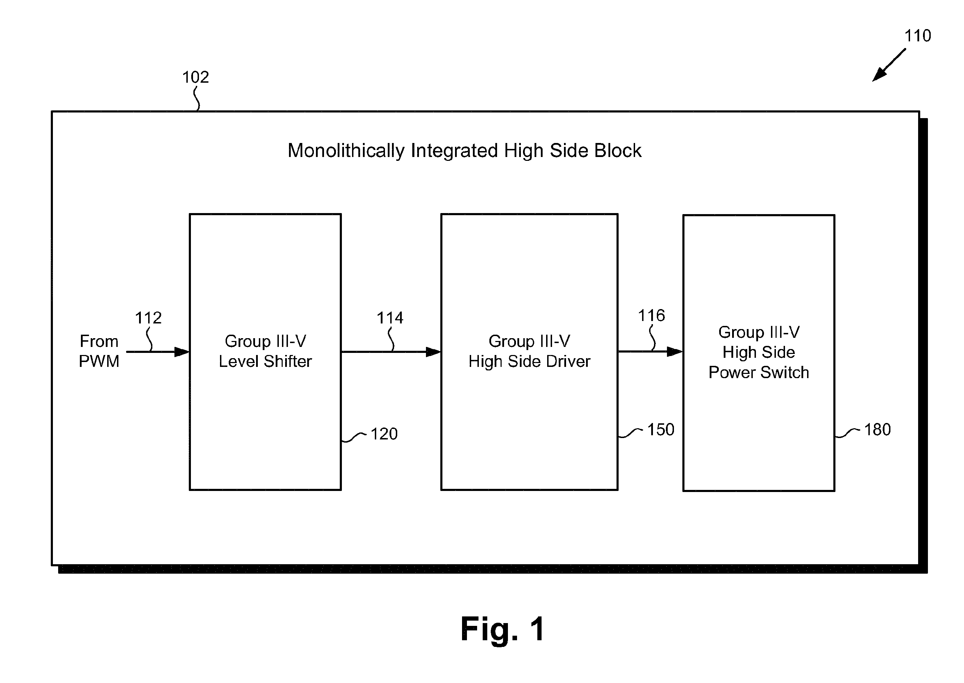

Figure 1 shows a diagram of monolithically integrated group III-V high side block 110, according to one exemplary implementation. Monolithically integrated high side block 110 includes group III-V level shifter 120, group III-V high side driver 150, and group III-V high side power switch 180. As shown in Figure 1, group III-V level shifter 120 is configured to receive control signal 112 for group III-V high side power switch 180, such as a pulse-width modulation (PWM) signal, for example. Typically, such a PWM signal is generated by a low voltage, ground referenced circuit, while the gate of group III-V high side power switch 180 is driven by a voltage referenced to the switch node (not shown in Figure 1), which is a high voltage rail relative to ground. According to the implementation shown in Figure 1, this level shifting of the drive signal for group III-V high side power switch 180 is performed by group III-V level shifter 120. As further shown in Figure 1, group III-V high side driver 150 is coupled to group III-V level shifter 120, and is configured to receive level shifted control signal 114 from group III-V level shifter 120.

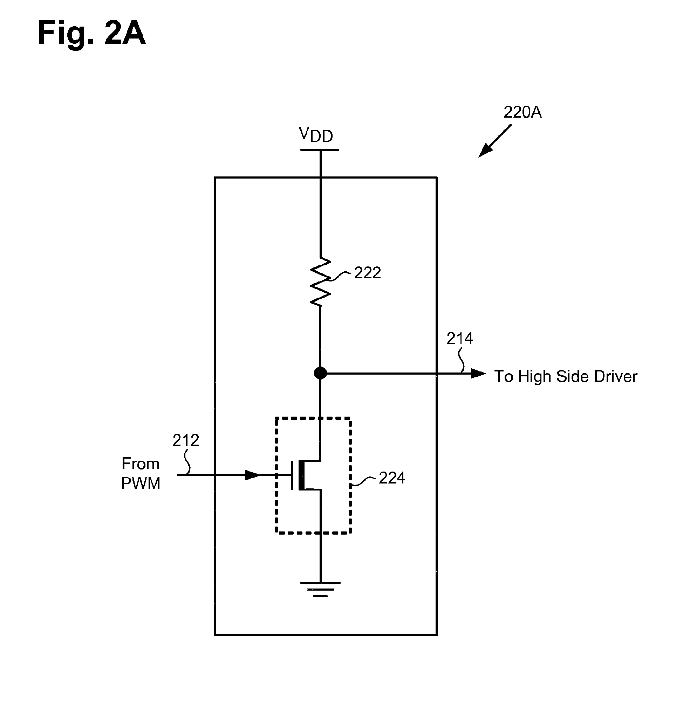

Group III-V high side power switch 180 is coupled to group III-V high side driver 150, and is configured to be driven by drive signal 116 generated by group III-V high side driver 150. As also shown in Figure 1, group III-V high side power switch 180 is monolithically integrated with group III-V high side driver 150 and group III-V level shifter 120 on common die 102. Moreover, and as will be disclosed in greater detail by reference to Figures 2A, 2B, 3, 4A, and 4B below, each of group III-V level shifter 120, group III-V high side driver 150, and group III-V high side power switch 180 includes at least one group III-V device.

It is noted that, although not explicitly shown in Figure 1, additional conditioning circuitry may be utilized to provide level shifted control signal 114 to group III-V high side driver 150. Such conditioning circuitry may be integrated with group III-V level shifter 120, or may be implemented as a separate conditioning block between group III-V level shifter 120 and group III-V high side driver 150. For example, the conditioning circuitry may include a logic block including a latching circuit implemented using flip flops and the like, as well as a filtering block to provide substantial noise immunity. The logic block may be configured to reduce power dissipation by enabling level shifting transistors included in group III-V level shifter 120 to be turned off during a portion of the on-time and the off-time of group III-V high side power switch 180.

In certain implementations, common die 102 includes a silicon or silicon-on-insulator substrate. When such a die is used for integration, additional elements and device configurations may also be formed in the silicon substrate. These may include additional integration elements such as vias described in U.S. Patent Number 7,821,034, entitled "Integrated III-Nitride Devices", filed on January 8, 2007, and issued on October 26, 2010; U.S. Patent Number 6,611,002, entitled "Gallium Nitride Material Devices and Methods Including Backside Vias", filed on February 23, 2001, and issued on August 26, 2003; U.S. Patent Number 7,566,913, entitled "Gallium Nitride Material Devices Including Conductive Regions and Methods Associated with the Same", filed on December 4, 2006, and issued on July 28, 2009; U.S. Patent Number 7,999,288, entitled "High Voltage Durability III-Nitride Semiconductor Device", filed on December 14, 2009, and issued on August 16, 2011; and U.S. Patent Application Serial Number 14/140,222, entitled "Semiconductor Structure Including a Spatially Confined Dielectric Region", filed on December 24, 2013. The above identified patents and patent application are hereby incorporated fully by reference into the present application.

Moving to Figure 2A, Figure 2A shows a diagram of exemplary group III-V level shifter 220A suitable for use in a monolithically integrated group III-V high side block, according to one implementation. Group III-V level shifter 220A is designed to transmit a ground reference signal received as control signal 212 to a gate of the group III-V high side power switch through high side driver circuitry (high side power switch and high side driver circuitry not shown in Figure 2A). As shown in Figure 2A, group III-V level shifter 220A includes resistor 222 and group III-V transistor 224, and is configured to provide level shifted control signal 214 to the high side driver.

Group III-V level shifter 220A receiving control signal 212 and providing level shifted control signal 214 corresponds in general to group III-V level shifter 120 receiving control signal 112 and providing level shifted control signal 114, in Figure 1. It is noted that in addition to the features shown in Figure 2A, group III-V level shifter 220A will typically include additional features that are not shown in the interests of conceptual clarity. Such additional features may include a flip flop and/or other logic circuitry, as well as passive circuit elements (e.g., pull-up resistors, capacitors, and the like), as required. Moreover, and as noted above by reference to Figure 1, those additional features may include conditioning circuitry including a logic block enabling reduction in power dissipation, and a filtering block providing substantial noise immunity.

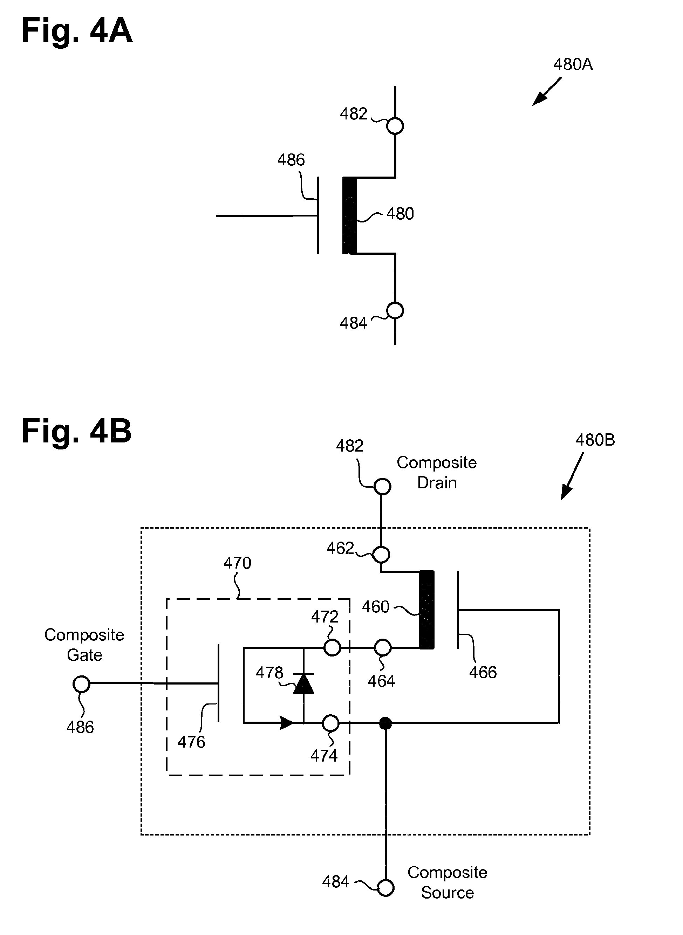

Group III-V transistor 224 of group III-V level shifter 220A may take the form of a III-Nitride or other group III-V FET or HEMT, and may be implemented as either a depletion mode (normally on) or as an enhancement mode (normally off) FET or HEMT. Alternatively, in some implementations, it may be advantageous or desirable to implement group III-V transistor 224 as a composite transistor including at least one depletion mode group III-V depletion mode device and at least one enhancement mode device. One example of such a composite transistor, formed as an enhancement mode transistor from the cascoded combination of a depletion mode III-Nitride HEMT with an enhancement mode silicon or other group IV FET is shown and described below by reference to Figure 4B.

As another alternative, a composite device using a depletion mode high voltage (HV) III-V device and a low voltage (LV) or midvoltage (MV) enhancement mode group III-V device can be used. It is noted that the features HV, LV, and MV are defined above in the Definition section of the present application. Examples of such composite devices can be found in U.S. Patent Number 8,264,003, entitled "Merged Cascode Transistor", filed on March 20, 2007, and issued on September 11, 2012; and U.S. Patent Application Serial Number 14/539,885, entitled "Dual-Gated Group III-V Merged Transistor", filed on November 12, 2014. The above identified patent and patent application are hereby incorporated fully by reference into the present application.

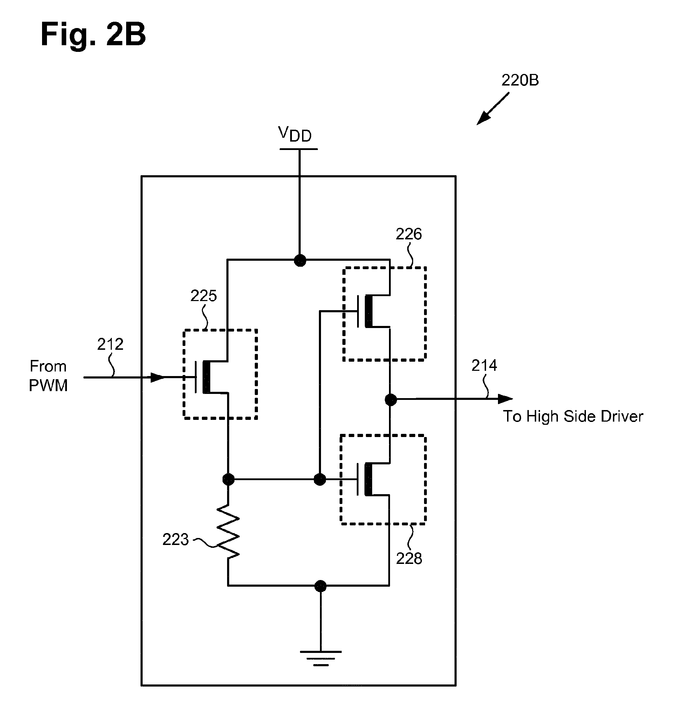

Referring to Figure 2B, Figure 2B shows a diagram of exemplary group III-V level shifter 220B suitable for use in a monolithically integrated group III-V high side block, according to another implementation. Group III-V level shifter 220B is designed to transmit a ground reference signal received as control signal 212 to a gate of the group III-V high side power switch through high side driver circuitry (high side power switch and high side driver circuitry not shown in Figure 2B). As shown in Figure 2B, group III-V level shifter 220B includes resistor 223 and group III-V transistors 225, 226, and 228. As further shown in Figure 2B, group III-V level shifter 220B is configured to provide level shifted control signal 214 to the high side driver.

Group III-V level shifter 220B receiving control signal 212 and providing level shifted control signal 214 corresponds in general to group III-V level shifter 120 receiving control signal 112 and providing level shifted control signal 114, in Figure 1. It is noted that in addition to the features shown in Figure 2B, group III-V level shifter 220B will typically include additional features that are not shown in the interests of conceptual clarity. As noted above by reference to Figure 2A, such additional features may include a flip flop and/or other logic circuitry, as well as passive circuit elements (e.g., pull-up resistors, capacitors, and the like), as required. Moreover, and as noted above by reference to Figure 1, those additional features may include conditioning circuitry including a logic block enabling reduction in power dissipation, and a filtering block providing substantial noise immunity.

Any or all of group III-V transistors 225, 226, and 228 may take the form of III-Nitride or other group III-V FETs or HEMTs, and may be implemented as either depletion mode (normally on) or as enhancement mode (normally off) FETs or HEMTs. Alternatively, in some implementations, it may be advantageous or desirable to implement one or more of group III-V transistors 225, 226, and 228 as a composite transistor including at least one group III-V device and at least one group IV device. As also noted above, one example of such a composite transistor, formed as an enhancement mode transistor from the cascoded combination of a depletion mode III-Nitride HEMT with an enhancement mode silicon FET is shown and described below by reference to Figure 4B.

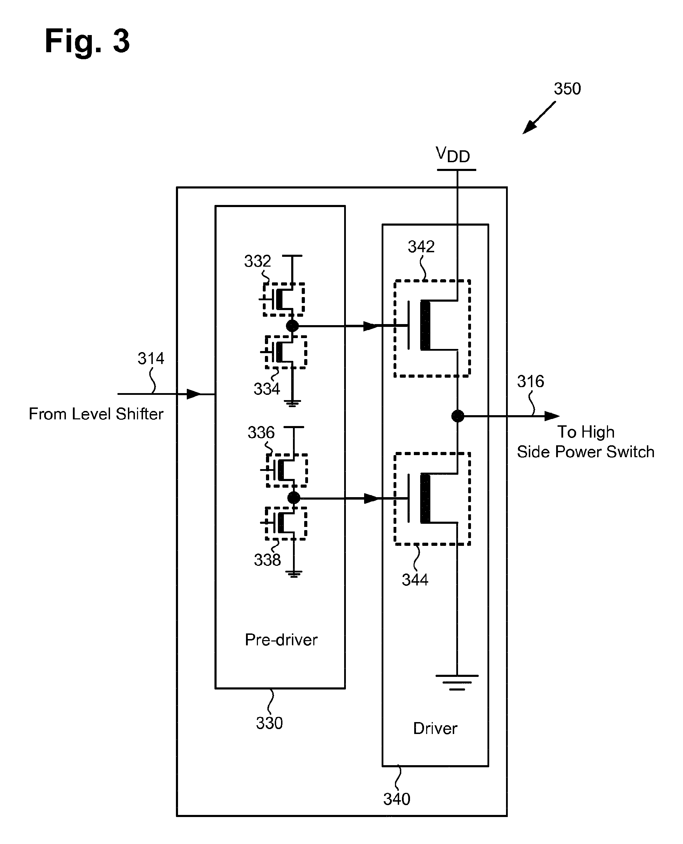

Continuing to Figure 3, Figure 3 shows a diagram of group III-V high side driver 350 suitable for use in a monolithically integrated group III-V high side block, according to one implementation. Group III-V high side driver 350 includes driver stage 340 and may also include pre-driver 330. As shown in Figure 3, group III-V high side driver 350 is configured to receive level shifted control signal 314 and to output drive signal 316 for driving a high side power switch (high side power switch not shown in Figure 3). Group III-V high side driver receiving level shifted control signal 314 and providing drive signal 316 corresponds in general to group III-V high side driver 150 receiving level shifted control signal 114 and providing drive signal 116, in Figure 1.

According to the implementation shown in Figure 3, driver stage 340 of group III-V high side driver 350 includes group III-V transistors 342 and 344 configured as a half bridge coupled between voltage source V_{DD} and ground. Either or both of group III-V transistors 342 and 344 may take the form of III-Nitride or other group III-V FETs or HEMTs, and may be implemented as either depletion mode (normally on) or as enhancement mode (normally off) FETs or HEMTs, or as composite group III-V devices. Alternatively, in some implementations, it may be advantageous or desirable to implement one or both of group III-V transistors 342 and 344 as a composite transistor including at least one group III-V device and at least one group IV device.

In implementations in which high side driver stage 350 includes pre-driver 330, pre-driver 330 may include group III-V transistors 332 and 334 coupled to driver stage group III-V transistor 342, and group III-V transistors 336 and 338 coupled to driver stage group III-V transistor 344. As shown in Figure 3, pre-driver 330 may include group III-V transistors 332 and 334 implemented as a first pre-driver half bridge and group III-V transistors 336 and 338 implemented as a second pre-driver half bridge. Analogously to group III-V transistors 342 and 344 of driver stage 340, any or all of pre-driver group III-V transistors 332, 334, 336, and 338 may take the form of depletion mode or enhancement mode group III-V FETs or HEMTs, or may be implemented as composite transistors.

Continuing to Figure 4A, Figure 4A shows exemplary group III-V transistor 480A, which is an example of a "group III-V device" in the present application, suitable for use in a monolithically integrated group III-V high side block, according to one implementation. Group III-V transistor 480A is shown to include drain 482, source 484, and gate 486. It is noted that any or all of the group III-V switches or transistors shown and described in the present application may be implemented using exemplary group III-V transistor 480A. In other words group III-V high side power switch 180, in Figure 1, and/or any or all of group III-V transistors 224, 225, 226, and 228 in Figures 2A and 2B, and/or any or all of group III-V transistors 332, 334, 336, 338, 342, and 344 in Figure 3 can be implemented using group III-V transistor 480A.

In one implementation, group III-V transistor 480A may take the form of a group III-V HEMT having drain 482, source 484, and gate 486, such as a III-Nitride HEMT. In some implementations, group III-V transistor 480A may be implemented as a depletion mode or enhancement mode insulated-gate FET (IGFET), junction FET (JFET), accumulation mode FET (AccuFet), or as a depletion mode or enhancement mode heterostructure FET (HFET) or HEMT, for example. In some implementations, group III-V transistor 480A may take the form of an enhancement mode metal-insulator-semiconductor FET (MISFET), such as a metal-oxide-semiconductor FET (MOSFET), or as a composite III-Nitride device including a depletion mode III-Nitride device and an enhancement mode III-Nitride device. Moreover, when implemented as group III-V high side power switch 180, in Figure 1, for example, group III-V transistor 480A may be an HV transistor. Thus, group III-V transistor 480A can take the form of an HV group III-V transistor such as an HV III-Nitride FET or HEMT.

Referring to Figure 4B, in power management applications where normally off characteristics of power devices are advantageous, a depletion mode group III-V transistor having desirable on-state characteristics, such as a low on-resistance, can be implemented in combination with an enhancement mode LV transistor to produce an enhancement mode composite transistor. For example, a III-Nitride or other group III-V FET or HEMT may be cascoded with an LV silicon or other group IV FET to provide a high performance composite transistor. Alternatively, a composite III-Nitride device including a depletion mode III-Nitride device and an enhancement mode III-Nitride device can be used.

Several examples of cascoded III-Nitride switches are disclosed in U.S. Patent Number 8,017,978, entitled "Hybrid Semiconductor Device", filed on March 10, 2006, and issued on September 13, 2011; U.S. Patent Number 8,084,783, entitled "GaN-Based Device Cascoded with an Integrated FET/Schottky Diode Device", filed on November 9, 2009, and issued on December 27, 2011; U.S. Patent Application Number 13/433,864, entitled "Stacked Composite Device Including a Group III-V Transistor and a Group IV Lateral Transistor", filed on March 29, 2012, and published as U.S. Patent Application Publication Number 2012/0256188 on October 11, 2012; U.S. Patent Application Number 13/434,412, entitled "Stacked Composite Device Including a Group III-V Transistor and a Group IV Vertical Transistor", filed on March 29, 2012, and published as U.S. Patent Application Publication Number 2012/0256189 also on October 11, 2012; and U.S. Patent Application Number 13/780,436, entitled "Group III-V and Group IV Composite Switch", filed on February 28, 2013, and published as U.S. Patent Application Publication Number 2013/0240898 on September 19, 2013. Additional techniques to integrate cascoded III-Nitride and silicon based switches are described in U.S. Patent Number 7,915,645, entitled "Monolithic Vertically Integrated Composite Group III-V and Group IV Semiconductor Device and Method For Fabricating Same", filed on May 28, 2009, and issued on March 29, 2011. The above identified patents and patent applications are hereby incorporated fully by reference into the present application.

Figure 4B shows exemplary composite transistor 480B, which is an example of a "group III-V device" in the present application, suitable for use in a monolithically integrated group III-V high side block, according to one implementation. Composite transistor 480B includes III-Nitride or other group III-V transistor 460, which may be a depletion mode transistor, and enhancement mode LV silicon or other group IV transistor 470. As shown in Figure 4B, group III-V transistor 460 is shown as a HEMT having drain 462, source 464, and gate 466, while LV group IV transistor 470 is shown as a FET having drain 472, source 474, and gate 476, and also including body diode 478.

It is noted that any or all of the group III-V switches or transistors shown and described in the present application may be implemented using exemplary composite transistor 480B. In other words group III-V high side power switch 180, in Figure 1, and/or any or all of group III-V transistors 224, 225, 226, and 228 in Figures 2A and 2B, and/or any or all of group III-V transistors 332, 334, 336, 338, 342, and 344 in Figure 3 can be implemented using a composite transistor analogous to composite transistor 480B. However, it is noted that the pre-driver function provided by group III-V transistors 332, 334, 336, and 338, and the driver function provided by group III-V transistors 342 and 344 are typically performed as LV operations. As a result, when implemented as composite transistors, group III-V transistors 332, 334, 336, 338, 342, and 344 may include lower voltage rated group IV and group III-V devices than those described below by reference to composite transistor 480B.

Enhancement mode LV group IV transistor 470 may be implemented as an enhancement mode silicon transistor, for example. According to one implementation, enhancement mode LV group IV transistor 470 may be a silicon MISFET or MOSFET. However, in other implementations, enhancement mode LV group IV transistor 470 may include any suitable group IV material, such as silicon carbide (SiC), germanium (Ge), silicon germanium (SiGe), or a strained group IV element or compound, for example. In some implementations, as shown in Figure 4B, enhancement mode LV group IV transistor 470 may include body diode 478 coupled across source 474 and drain 472 of enhancement mode LV group IV transistor 470.

Group III-V transistor 460 may be implemented as a depletion mode IGFET, JFET, AccuFet, or HFET, for example. When implemented as an HFET, group III-V transistor 460 may be a HEMT configured to produce a 2DEG.

The combination of depletion mode group III-V transistor 460 and enhancement mode LV group IV transistor 470 provides composite transistor 480B, which according to the implementation shown in Figure 4B can be configured as a composite three terminal device functioning in effect as an enhancement mode composite transistor having composite drain 482 provided by depletion mode group III-V transistor 460, and composite source 484 and composite gate 486 provided by enhancement mode LV group IV transistor 470.

In some implementations, composite transistor 480B may be a monolithically integrated composite transistor in which depletion mode group III-V transistor 460 and enhancement mode LV group IV transistor 470 are fabricated on a common die. However, in some implementations, LV group IV transistor 470 may be fabricated on a discrete silicon die mounted to a group III-V die on which depletion mode group III-V transistor is formed, as disclosed in U.S. Patent Number 8,847,408, entitled "III-Nitride Transistor Stacked with FET in a Package", filed on March 22, 2011, and issued on September 30, 2014. This patent is hereby incorporated fully by reference into the present application.

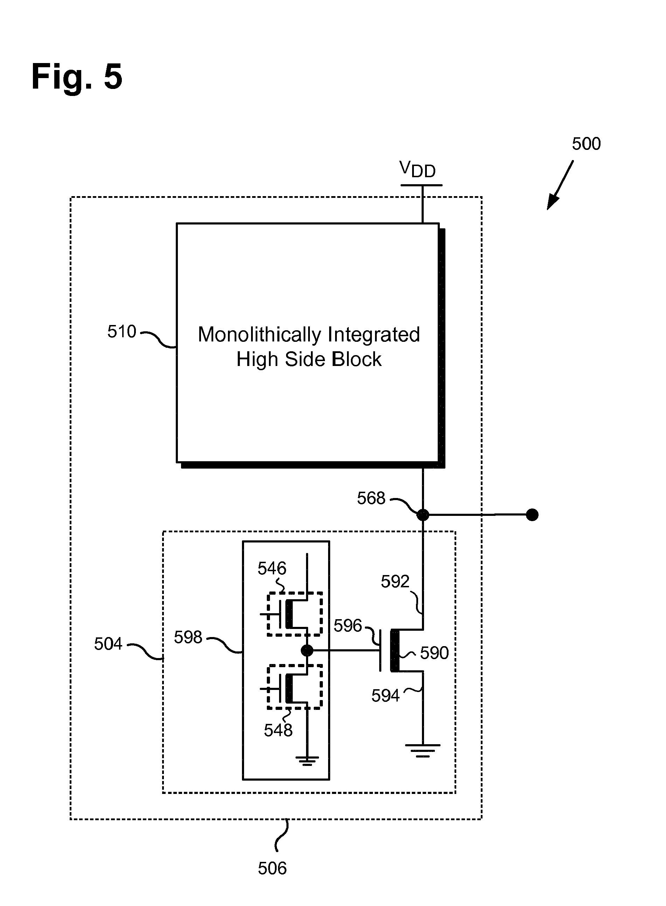

Continuing to Figure 5, Figure 5 shows a diagram of voltage converter 500 including monolithically integrated high side block 510, according to one exemplary implementation. In addition to monolithically integrated high side block 510, voltage converter 500 includes low side power switch 590 having drain 592 coupled to monolithically integrated high side block 510 at switch node 568, and source 594 coupled to ground. Voltage converter 500 further includes low side driver 598 coupled to gate 596 of low side power switch 590. Also shown in Figure 5 are low side driver transistors 546 and 548, optional low side common die 504, and optional power stage common die 506.

Monolithically integrated high side block 510 corresponds in general to monolithically integrated high side block 110, in Figure 1, and may share any of the characteristics attributed to the features of integrated high side block 110 by reference to Figures 1, 2A, 2B, 3, 4A, and 4B, above. According to the exemplary implementation shown in Figure 5, voltage converter 500 may be implemented using a half bridge configuration in which monolithically integrated high side block 510 is coupled between V_{DD} and switch node 568, and low side power switch 590 is coupled between switch node 568 and ground. It is noted, however, that in addition to the half bridge configuration shown in Figure 5, in other implementations, voltage converter 500 may assume other switch configurations, and may be implemented using a full bridge or three-phase bridge circuit configuration, for example.

According to the implementation shown in Figure 5, low side driver 598 includes transistors 546 and 548 configured as a half bridge. Any or all of low side power switch 590 and transistors 546 and 548 may take the form of III-Nitride or other group III-V FETs or HEMTs, and may be implemented as either depletion mode (normally on) or as enhancement mode (normally off) FETs or HEMTs. In such implementations, any or all of low side power switch 590 and transistors 546 and 548 may correspond in general to group III-V transistor 480A, in Figure 4A, and may share any of the features attributed to group III-V transistor 480A, above.

However, in some implementations, it may be advantageous or desirable to implement one or more of low side power switch 590 and transistors 546 and 548 as a composite transistor including at least one group III-V device and at least one group IV device. In those implementations, any or all of low side power switch 590 and transistors 546 and 548 may correspond in general to composite transistor 480B, in Figure 4B, and may share any of the features attributed to composite transistor 480B, above.

In some implementations, the advantages associated with monolithic integration of transistors on a common die may be extended to low side power switch 590 and/or low side driver 598. For example, in one implementation, low side power switch 590 and low side driver 598 may be monolithically integrated together on low side common die 504. Moreover, in implementations in which larger scale monolithic integration may be advantageous or desirable, one or both of low side power switch 590 and low side driver 598 may be monolithically integrated with monolithically integrated high side block 510 on power stage common die 506.

Thus, the present application is directed to implementations of a monolithically integrated high side block configured to overcome the deficiencies associated with conventional solutions utilizing silicon based transistors to provide high side driver and level shifter circuitry. In various implementations, a monolithically integrated high side block according to the present inventive concepts may integrate a high side group III-V power switch, as well as the high side driver and level shifter for the high side group III-V power switch, on a common die. Moreover, the switching devices utilized in either or both of the high side driver and level shifter may be implemented as group III-V depletion mode (i.e., normally on), group III-V enhancement mode (i.e., normally off), or composite devices. The monolithically integrated high side block disclosed herein enables advantageous reduction in the size and cost of the high side power switching circuitry, while improving performance by reducing parasitic inductances and capacitances associated with device layout and interconnection.

From the above description it is manifest that various techniques can be used for implementing the concepts described in the present application without departing from the scope of those concepts. Moreover, while the concepts have been described with specific reference to certain implementations, a person of ordinary skill in the art would recognize that changes can be made in form and detail without departing from the scope of those concepts. As such, the described implementations are to be considered in all respects as illustrative and not restrictive. It should also be understood that the present application is not limited to the particular implementations described herein, but many rearrangements, modifications, and substitutions are possible without departing from the scope of the present disclosure.

## Claims

1. A normally off composite power device comprising:
a normally on power transistor providing a composite drain of said normally off composite power device;
a normally off low voltage (LV) transistor cascoded with said normally on power transistor, said normally off LV transistor providing a composite source and a composite gate of said normally off composite power device;
an ESD protection clamp coupled between said composite source and said composite gate, said ESD protection clamp configured to provide electrostatic discharge (ESD) protection for said normally off composite power device.

2. The normally off composite power device of claim 1, wherein said ESD protection clamp is a discrete diode that is not monolithically integrated with said normally on power transistor and said normally off LV transistor.

3. The normally off composite power device of claim 1, wherein said normally off LV transistor and said ESD protection clamp are monolithically integrated.

4. The normally off composite power device of claim 1, wherein said normally on power transistor and said normally off LV transistor and said ESD protection clamp are monolithically integrated.

5. The normally off composite power device of claim 1, wherein said normally on power transistor and said normally off LV transistor are monolithically integrated.

6. The normally off composite power device of claim 1, wherein said normally on power transistor is a high voltage (HV) group III-V transistor.

7. The normally off composite power device of claim 1, wherein said normally on power transistor comprises a III-Nitride high electron mobility transistor (HEMT).

8. The normally off composite power device of claim 1, wherein said normally off LV transistor comprises a group IV field-effect transistor (FET).

9. The normally off composite power device of claim 1, wherein said normally off LV transistor comprises a silicon FET.

10. The normally off composite power device of claim 1, wherein said normally off LV transistor and said ESD protection clamp comprise silicon devices.

11. The normally off composite power device of claim 1, wherein a drain of said normally off LV transistor is coupled to a source of said normally on power transistor, a source of said normally off LV transistor providing said composite source, and a gate of said normally off LV transistor providing said composite gate, a drain of said normally on power transistor providing said composite drain, a gate of said normally on power transistor being coupled to said source of said normally off LV transistor and to an anode of said ESD protection clamp.

12. The normally off composite power device of claim 1, wherein said ESD protection clamp comprises a combination of transistors, and/or diodes and/or resistors that are not monolithically integrated with said normally on power transistor and said normally off LV transistor.

13. The normally off composite power device of claim 1, wherein said ESD protection clamp comprises a combination of transistors, and/or diodes and/or resistors that are monolithically integrated with said normally on power transistor and said normally off LV transistor.

14. The normally off composite power device of claim 1, wherein said ESD protection clamp comprises at least one diode that is monolithically integrated with said normally on power transistor and said normally off LV transistor.

15. A monolithically integrated normally off composite power device comprising:
a normally on power transistor providing a composite drain of said normally off composite power device;
a normally off low voltage (LV) transistor cascoded with said normally on power transistor, said normally off LV transistor providing a composite source and a composite gate of said normally off composite power device;
an ESD protection clamp coupled between said composite source and said composite gate, said ESD protection clamp configured to provide electrostatic discharge (ESD) protection for said normally off composite power device;
wherein said normally on power transistor, said normally off LV transistor, and said ESD protection clamp are monolithically integrated.
